# EUROPEAN PATENT APPLICATION

(11) **EP 4 401 246 A1**
(43) Date of publication of application: **17.07.2024**
(21) Application number: 23382030.7
(22) Date of filing: 16.01.2023
(51) Int. Cl.: H01R 4/52, H01R 4/30, H02M 1/00, H02M 7/00, H05K 7/14, H01R 4/36, H01R 9/24, H01R 11/12

(54) **POWER CONVERTER**

(71) Applicant: EPL Engineering S.L., 20014 Donostia (ES)
(72) Inventor: DESCARREGA DE LA VEGA, Xavier, 43740 Mora d´Ebre (ES); VERPOORTEN, Roel, 3270 Scherpenheuvel (BE)
(74) Representative: Igartua, Ismael

(57) **Abstract**

Power converter comprising a casing (10) with a first connection portion (11) for connecting first cables (1) and a second connection portion (12) for connecting second cables (5), a first busbar having connection plates, a second busbar having other connection plates, a first connector for establishing a quick connection/disconnection of the connection plates of the first busbar with respect to the connection terminals (2) of the first cables (1) and a second connector for establishing a quick connection/disconnection of the connection plates of the first busbar with respect to the connection terminals (2) of the second cables (5).

## Description

### TECHNICAL FIELD

The present invention relates to a power converter for converting DC power supply into AC power supply, AC power supply into DC power supply, or for adapting DC to DC power supply.

### PRIOR ART

A DC/AC or AC/DC power converter, also referred to as power inverter, generally comprises a capacitor module which receives DC (direct current) power supply from DC equipment, and an inverter module which receives DC power supply from the capacitor module and generates an AC (alternating current) power supply to power AC equipment. For example, in an electric vehicle, the DC equipment can be a battery that generates DC power supply which is converted into AC power supply by the inverter module and sent to the AC equipment, which can be the engine of the electric vehicle.

For example, EP2660969A1 shows a power converter comprising a casing with a DC connection portion for connecting first cables and an AC connection portion for connecting second cables, a capacitor module with a DC busbar having connection plates for establishing an electrical connection with the connection terminals of the first cables, and an inverter module with an AC busbar having connection plates for establishing an electrical connection with the connection terminals of the second cables, with the capacitor module being connected with the inverter module.

For example, in high-voltage applications of between 100 Volts and 1200 Volts, cables having connection terminals with a flat portion with a hole, generally known as "clug" type terminals (cable lug), are used to connect the power converter with DC and AC equipment. To ensure proper current transmission, the flat portion of the connection terminals must be suitably supported on the flat surface of the connection plates of the busbars, given that hot spots may be generated if the support is localized and there is little contact surface between the terminals and the plates.

To ensure contact, the cables can incorporate in the connection terminals connectors specifically designed to be coupled to the power converter, said connectors being the ones which are connected to the connection plates of the busbars (see, for example, US2021013663A1), or the flat portion of the connection terminals of the cables can be connected directly to the connection plates of the busbars, to that end, each connection plate has a hole which is aligned with the hole of the flat portion of the connection terminal, and the connection plate is fixed to the flat portion of the connection terminal by means of a screw with a thread. In this case, the connection plates are located inside the casing of the power converter, such that the casing has windows of considerable dimensions in order to introduce the screws and to enable viewing the connection terminal from the outside and to enable aligning the hole of the flat portion of the connection terminal with the hole of the connection plate.

### DISCLOSURE OF THE INVENTION

The object of the invention is to provide a power converter for converting DC power supply into AC power supply, AC power supply into DC power supply, or for adapting DC to DC power supply, as defined in the claims.

One aspect of the invention relates to a power converter comprising a casing with a first connection portion for connecting first cables having connection terminals with a flat portion with a hole and a second connection portion for connecting second cables having connection terminals with a flat portion with a hole, a first busbar having connection plates for establishing an electrical connection with the connection terminals of the first cables, and a second busbar having connection plates for establishing an electrical connection with the connection terminals of the second cables.

According to the invention, at least one of the connection portions comprises a connector for connecting the flat portion of the connection terminals with the connection plates. The connector comprises a connector body with a housing which houses a first movable part and a second movable part which are axially movable in the housing of the connector body, and a spring having one end attached to the connector body and another end attached to the first movable part, the spring going through one of the connection plates, and the connection plate being arranged between the first movable part and the connector body.

The first movable part has a lower portion which is pressed by the spring and an upper portion in which the flat portion of one of the connection terminals is insertable.

The second movable part is configured to receive a force which axially moves the second movable part and the first movable part, overcoming the pressure of the spring. The second movable part has a threaded hole for screwing a set screw therein between an initial screwed-in position in which there is no electrical contact between the connection terminal and the connection plate, and a final screwed-in position in which there is electrical contact between the connection terminal and the connection plate.

In this way, when the connection terminal is inserted and the set screw is in the final screwed-in position, the set screw presses the connection terminal against the first movable part, overcoming the pressure of the spring and establishing electrical contact between the connection terminal and the connection plate through the first movable part; and when the connection terminal is inserted and the set screw is in the initial screwed-in position, by applying force on the second movable part, the second movable part and the first movable part are moved, overcoming the pressure of the spring and releasing the connection terminal.

A compact power converter having a connector integrated inside the casing for establishing an electrical connection between a connection plate and the flat portion of one of the connection terminals is thereby obtained, such that it is not necessary for the cables to have an external connector in order to be connected to the power converter, as occurs, for example, in US2021013663A1. The connector ensures electrical contact between the flat surface of the plate and the flat portion of the connection terminal, maximizing the contact surface between both and thereby preventing the occurrence of hot spots. Furthermore, the movable parts allow establishing a quick connection and disconnection of the connection terminal. The set screw is housed inside the connector and partially screwed into its movable part, preventing accidental loss or removal.

These and other advantages and features of the invention will become apparent in view of the figures and detailed description of the invention.

### DESCRIPTION OF THE DRAWINGS

Figure 1 shows a perspective view of an embodiment of the power converter of the invention observed from the DC connection portion.
Figure 2 shows another perspective view of the embodiment of the power converter of the invention observed from the AC connection portion.
Figure 3 shows a plan view of the embodiment of the power converter without the cover of the casing.
Figure 4 shows a top plan view of the embodiment of the power converter, but without the electronic board, showing the power modules and the current sensors of the inverter module.
Figure 5 shows an exploded perspective view of the elements making up a DC connector which is arranged in the DC connection portion.
Figures 5a to 5c show the first movable part, the second movable part, and the cage of the DC connector.
Figure 6 shows a front view of the DC connector of Figure 5.
Figures 7a to 7d show the steps for connecting a connection terminal in the DC connector.
Figure 8 shows an exploded perspective view of the elements making up an AC connector which is arranged in the AC connection portion.
Figure 8a shows an enlarged perspective view of the movable part of Figure 8.
Figure 9a shows a perspective view of a current sensor which is arranged on one of the connection plates of the AC busbar.
Figure 9b shows a perspective view of the core made of a ferromagnetic material of the current sensor and Figure 9c shows a perspective view of the central support of the current sensor of Figure 9a.
Figure 10 shows a front view of the AC connector of Figure 8.
Figures 11a to 11d show the steps for connecting a connection terminal in the AC connector.

### DETAILED DISCLOSURE OF THE INVENTION

The invention relates to a power converter for converting DC power supply into AC power supply, AC power supply into DC power supply, or adapting DC to DC power supply.

The examples in the figures show an AC/DC or DC/AC power converter, also referred to as power inverter; however, the invention is also applicable to a DC/DC power converter.

The power converter is particularly suitable for electric mobility applications across land or sea. For example, it can be used in electric vehicles. By way of example, the electric vehicles can be motorcycles, cars, buses, railway vehicles, planes, ships, among others.

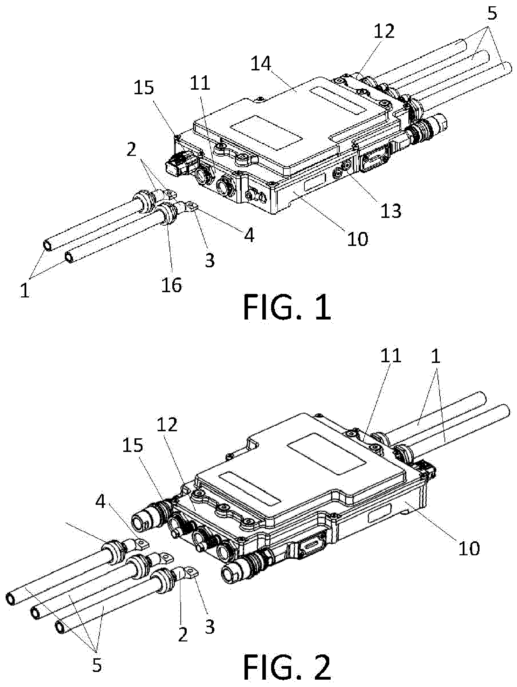

As can be seen in the example of Figures 1 and 2, the power converter comprises a casing 10 with a first connection portion 11 for connecting first cables 1 and a second connection portion 12 for connecting second cables 5.

In an (AC/DC or DC/AC) power inverter like the one depicted in the examples of the figures, the first connection portion 11 is a DC connection portion and the second connection portion 12 is an AC connection portion 12. In a DC/DC power converter, both connection portions 11 and 12 are DC connection portions.

Two first cables 1 are connected in the DC connection portion 11 and three second cables 5 are connected in the AC connection portion.

The first cables 1 are used to connect the DC connection portion 11 of the power converter with DC equipment (not depicted) and the second cables 5 are used to connect the AC connection portion 12 of the power converter with AC equipment (not depicted). For example, the DC equipment can be a power source which supplies DC power supply to the power converter and the AC equipment can be an engine which receives AC power supply from the power converter. In an electric vehicle, a battery may supply DC power supply and the power converter converts the DC power supply into AC power supply in order to power the engine of the electric vehicle.

The first cables 1 and the second cables 5 have connection terminals 2 with a flat portion 3 with a hole 4. The connection terminals 2 can be "clug" type terminals (cable lug) which are used, for example, in high-voltage applications of between 100 Volts and 1200 Volts.

The power converter has a capacitor module 200 and an inverter module 300. The capacitor module 200 has a DC busbar 210 with connection plates 211 and 212 which establish an electrical connection with the connection terminals 2 of the first cables 1. The inverter module 300 has an AC busbar 310 with connection plates 311, 312, and 313 which establish an electrical connection with the connection terminals of the second cables 5. The capacitor module 200 is connected with the inverter module 300.

The connection plates of the busbar 210 and 310 are made of an electrically conductive material. The connection plates can be made of metal such as, for example, copper, a copper alloy, an aluminum alloy, or stainless steel, and can have a surface treatment that improves electric transmission such as, for example, silver, tin, or aluminum. The connection terminals 2 of the cables 1 and 5 can be made of the same material as the connection plates of the busbar 210 and 310.

The capacitor module 200 smooths and stabilizes the DC power supply signal received by the DC connection portion 11 and the inverter module 300 converts the DC power supply signal into an AC power supply signal which is sent to the AC connection portion 12. The inverter module 300 has power modules 301, 302, and 303 with power transistors such as, for example, IGBT transistors, to convert the DC power supply signal into the AC power supply signal.

The power converter has in the DC connection portion 11 a DC connector 100 for establishing a quick connection/disconnection with respect to the connection terminals 2 of the first cables 1 and the power converter has in the AC connection portion 12 an AC connector 400 for establishing a quick connection/disconnection with respect to the connection terminals 2 of the second cables 5.

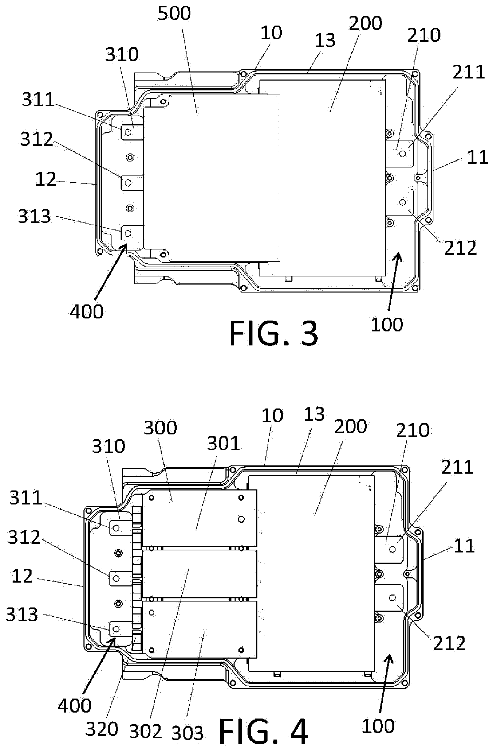

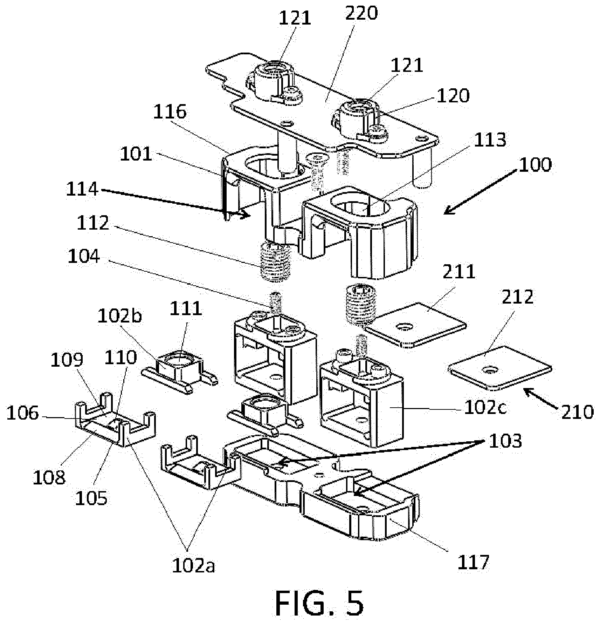

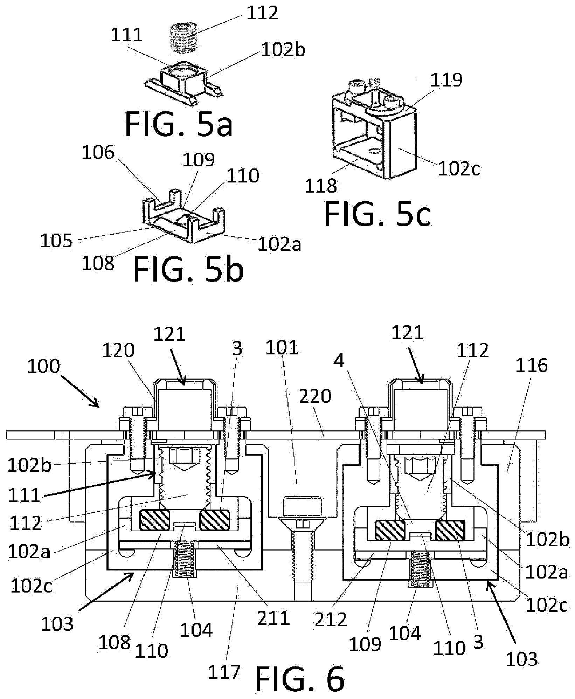

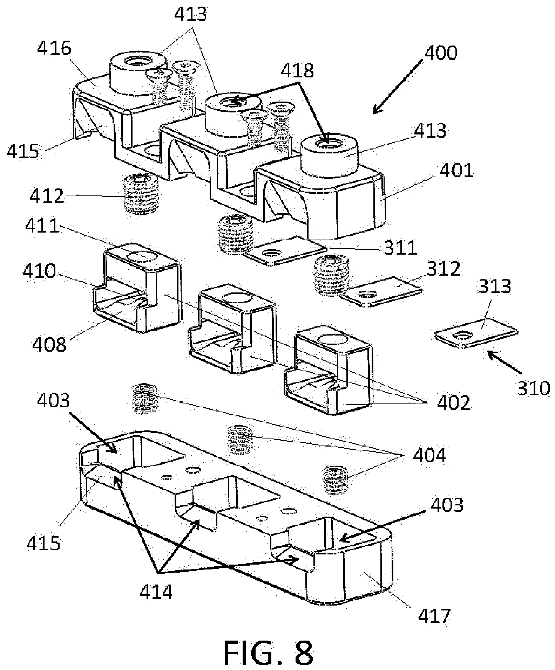

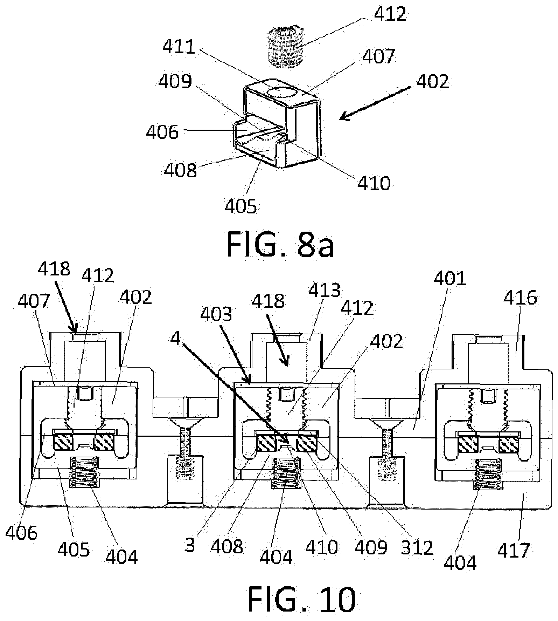

Figure 5 shows an exploded view of the elements making up the DC connector 100 and Figure 6 shows a view with said elements assembled. Figure 8 shows an exploded view of the elements making up the AC connector 400 and Figure 10 shows a view with said elements assembled. For the sake of clarity, the connectors 100 and 400 are not depicted in Figures 3 and 4 in order to be able to see the connection plates of the DC busbar 210 and AC busbar 310, such that references 100 and 400 indicate the space in the casing 10 where the connectors 100 and 400 are located. The DC connector 100 of the example of Figure 5 could be used as an AC connector and the AC connector 400 of the example of Figure 8 could be used as a DC connector.

The casing 10 is manufactured in a metallic material that acts as a Faraday cage to isolate the components of the power converter from electromagnetic noise. The casing 10 comprises a lower portion 13 in which housings are directly machined to house the DC connector 100, the capacitor module 200, the inverter module 300, and the AC connector 400. The lower portion 13 of the casing 10 is closed at the upper portion thereof by a cover 14 which ensures a hermetic isolation.

The casing 10 has threaded holes 15 for screwing therein cable glands 16 that fix the connection terminals 2 of the first cables 1 and the second cables 5 to the casing 10, with each connection terminal 2 being retained between a cable gland 16 and a threaded hole 15 of the casing 10. The connection terminals 2 of the cables 1 and 5 are therefore directly introduced into the casing 10 of the power converter in which the DC connector 100 and AC connector 400 are arranged, so it is not necessary for the cables 1 and 5 to have an external connector for connecting the connection terminals 2 to the power converter, as occurs, for example, in document US2021013663A1. This allows for a compact power converter.

As shown in the example of Figures 1 and 2, the casing 10 has in the DC connection portion 11 two threaded holes 15 for screwing therein two cable glands 16 that fix the two connection terminals 2 of the two cables 1 to the DC connection portion 11 of the power converter, and the casing 10 has in the AC connection portion 12 three threaded holes 15 for screwing therein three cable glands 16 that fix the two connection terminals 2 of the three cables 5 to the AC connection portion 12 of the power converter.

The DC connector 100 comprises a connector body 101 with a housing 103 which houses a first movable part 102a and a second movable part 102b which are axially movable in the housing 103 of the connector body 101, and a spring 104 having one end attached to the connector body 101 and another end attached to the first movable part 102A. The spring 104 goes through the connection plate 211 or 212, and the connection plate 211 or 212 is arranged between the first movable part 102a and the connector body 101. For example, one of the ends of the spring 104 is fitted in the connector body 401 and the other end is directly supported on first movable part 102a.

Preferably, as can be seen in detail in Figures 5 and 6, the connector body 101 of the DC connector 100 comprises, for each connection plate 211 and 212, a pair of movable parts 102a and 102b which are axially movable in a respective housing 103 of the connector body 101, and a respective spring 104 having one end attached to the connector body 101 and another end attached to its respective first movable part 102a.

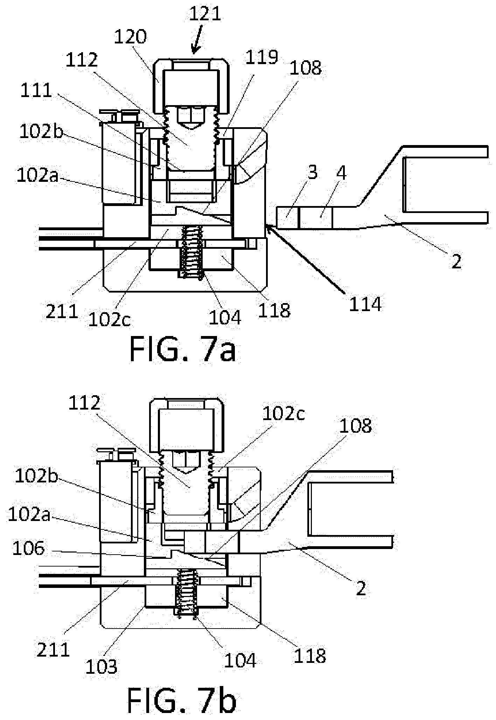

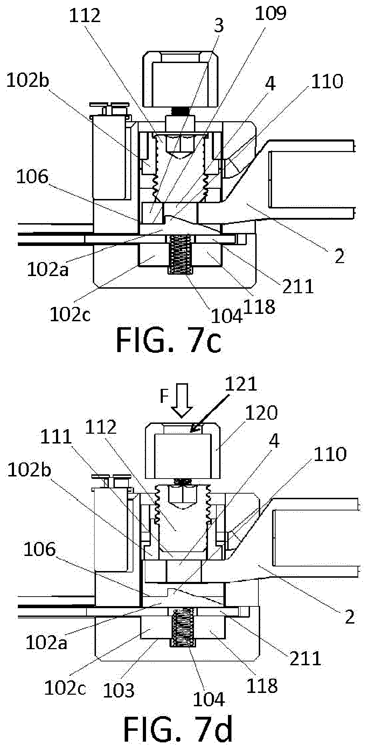

As can be seen in Figures 5a and 5b, the first movable part 102a has a lower portion 105 which is pressed by the spring 104 and an upper portion 106 in which the flat portion 3 of one of the connection terminals 2 is insertable. The second movable part 102b is configured to receive a force F and to axially move the second movable part 102b and the first movable part 102a, overcoming the pressure of the spring 104. The second movable part 102b has a threaded hole 111 for screwing a set screw 112 therein between an initial screwed-in position in which there is no electrical contact between the connection terminal 2 and the connection plate 211 or 212 (see Figures 7a, 7b, and 7d) and a final screwed-in position in which there is electrical contact between the connection terminal 2 and the connection plate 211 or 212 (see Figure 7c).

As can be seen in Figure 7c, when the connection terminal 2 is inserted in the upper portion 106 of the first movable part 102a and the set screw 112 is in the final screwed-in position, the set screw 112 presses the connection terminal 2 against the first movable part 102a, overcoming the pressure of the spring 104 and establishing electrical contact between the connection terminal 2 and the connection plate 211 or 212 through the first movable part 102a.

As can be seen in Figure 7d, when the connection terminal 2 is inserted in the upper portion 106 of the first movable part 102a and the set screw 112 is in the initial screwed-in position, by applying force F on the second movable part 102b, the second movable part 102b and the first movable part 102a are moved, overcoming the pressure of the spring 104 and releasing the connection terminal 2. In other words, the second movable part 102b drives the first movable part 102a, releasing the contact between the connection terminal 2 and the first movable part 102a.

The electrical connection between the flat portion 3 of each connection terminal 211 and 212 of the DC busbar 210 is established through the respective first movable part 102a, therefore, the first movable part 102a is made of an electrically conductive material. Preferably, the electrically conductive material comprises copper.

Preferably, the lower portion 105 of the first movable part 102a has a lower face attached to the spring 104 and an upper face with a ramp 108 for contacting the connection terminal 2, such that when the connection terminal 2 is inserted in the upper portion 106 of the first movable part 102, the connection terminal 2 contacts the ramp 108, overcoming the pressure of the spring 104 and axially moving the first movable part 102a. As can be seen in Figure 7b, the ramp 108 has an increasing slope in the direction of insertion of the connection terminal 2 which causes a gradual movement of the first movable part 102a.

Even more preferably, the lower portion 105 of the first movable part 102a has on the upper face a flat seating 109 for supporting the flat portion 3 of the connection terminal 2 when the connection terminal 2 is inserted in the upper portion 106 of the first movable part 102a, it is thereby ensured that the flat portion 3 of the connection terminal 2 has a wide surface to contact the first movable part 102a and that the risk of hot spots occurring due to a poor contact is minimized.

Even more preferably, the lower portion 105 of the first movable part 102a has on the upper face a projection 110 projecting from the flat seating 109, the projection 110 being fitted in the hole 4 of the flat portion 3 of the connection terminal 2 when the connection terminal 2 is inserted in the upper portion 106 of the first movable part 102a. The projection 110 retains the connection terminal 2, preventing the accidental removal thereof. Furthermore, during the insertion of the connection terminal 2, when the projection 110 is to be fitted in the hole 4 of the connection terminal 2, the first movable part 102a moves up suddenly until the flat seating 109 hits against the flat portion 3 of the connection terminal 2, generating a noise which can be used as a mechanical feedback signal to identify the proper coupling of the connection terminal 2 with the connection plate. This allows not having to have large windows in the casing 10 to enable viewing the connection terminal 2 from the outside and to enable viewing that the coupling between the terminal 2 and the plate is being properly performed, as occurs in known power converters.

As can be seen in detail in Figures 5a and 5b, the first movable part 102a has four columns projecting vertically from the upper portion 106 of the second movable part 102a, and the second movable part 102b has four horizontally projecting arms, with contact between the movable parts 102a and 102b being established through the columns and the arms. The height of the columns of the first movable part 102a is established based on the thickness of the flat portion 3 of the connection terminal 2 so as to allow insertion thereof and so that it does not hit the first movable part 102b.

The connector body 101 comprises a cage 102c which is arranged in the housing 103 of the connector body 101, and the first movable part 102a and the second movable part 102b are axially movable inside the cage 102c of the connector body 101, with the spring 104 going through the connection plate 211 or 212 and the lower portion 118 of the cage 102c, the connection plate 211 or 212 being arranged between the first movable part 102a and the lower portion 118 of the cage 102c. The cage 102c has in the lower portion 118 a hole for the passage of the spring 104. Preferably, as can be seen in detail in Figures 5 and 6, the connector body 101 of the DC connector 100 comprises, for each connection plate 211 and 212, a cage 102c which houses a pair of movable parts 102a and 102b.

As can be seen in Figures 5 and 6, an inlet filter 220 of the capacitor module 200 is coupled to the upper portion 119 of the cage 102c, with the inlet filter 220 being arranged above the cage 102c. The inlet filter 220 can be screwed therein by means of screws that fit into holes in the upper portion 119 of the cage 102c. The inlet filter 220 of the capacitor module 200 is thereby superimposed above the DC connector 100, whereby a more compact power converter is achieved.

The force F to axially move the second movable part 102b and the first movable part 102a, overcoming the pressure of the spring 104 and releasing the connection terminal 2, is applied by means of the set screw 112.

The set screw 112 is partially screwed into the threaded hole 111 and is part of the second movable part 102b, such that the possibility of losing the set screw 112 or of it falling into the casing 10, as may occur in power converters using large windows, is prevented.

The set screw 112 has a diameter greater than the hole of the connection plates 211 or 212 in order to prevent the passage of the screw 112 through said hole. Unlike known power converters, a nut and a screw which passes through the holes of the connection terminal 2 and the connection plate is not used, rather the connection terminal 2 and the connection plate are retained between the set screw 112 and the lower portion 118 of the cage 102c.

As can be seen in Figure 5, the connector body 101 has a hole 113 for receiving the set screw 112 and directing it towards the threaded hole 111 of the second movable part 102b.

As can be seen in Figure 6, the set screw 112 is partially screwed into the threaded hole 111 of the second movable part 102b, and the connector body 101 has a cap 120 with an inlet area 121 for a screwing tool having a diameter smaller than the diameter of the set screw 112 so as to allow screwing the set screw 112 therein and prevent it from coming out. In this way, the set screw 112 cannot be removed and the accidental loss thereof is prevented, the possibility of the set screw 112 contacting the casing 10 of the power converter and causing a short-circuit is also prevented.

As can be seen in Figure 5, the connector body 101 has an inlet opening 114 in order to direct the connection terminal 2 towards the upper portion 106 of the first movable part 102a.

Preferably, the connector body 101 comprises an upper half-body 116 and a lower half-body 117 which are screwed together to facilitate the assembly of the DC connector 100. The spring 104 of each housing 103 is arranged in the lower half-body 117 of the connector body 101.

Figures 7a to 7d show the steps for connecting a connection terminal 2 in the DC connector 100 and for releasing the connection terminal 2.

Figure 7a shows the connection terminal 2 facing the inlet opening 114 of the connector body 101. In that standby position, the ramp 108 of the first movable part 102a is facing the inlet opening 114 and the spring 104 is forcing the first movable part 102a to move upwards and there is no electrical contact between the connection terminal 2 and the connection plate 211 or 212. In that standby position, the second movable part 102b is also forced to move upwards driven by the first movable part 102a. The axial travel of the movable parts 102a and 102b is limited because the second movable part 102b abuts the upper half-body 116 of the connector body 401, more specifically the upper portion 119 of the cage 102c of the connector body 101.

In that standby position, the set screw 112 is in the initial screwed-in position. The set screw 112 is partially screwed into the threaded hole 111 of the second movable part 102b.

Figure 7b shows the connection terminal 2 in an intermediate insertion position partially inserted in the upper portion 106 of the first movable part 102a and contacting the ramp 108 so as to overcome the pressure of the spring 104 and to axially move the first movable part 102a downwards. The second movable part 102b together with the set screw 112 move down as a result of gravity together with the first movable part 102a. The set screw 112 remains in the initial screwed-in position.

Figure 7c shows the connection terminal 2 inserted in the upper portion 106 of the first movable part 102a and the set screw 112 in the final screwed-in position in which there is electrical contact between the flat portion 3 of the connection terminal 2 and the connection plate 211 or 212 of the DC busbar 210. In that electrical contact position, the projection 110 of the first movable part 102a is fitted in the hole 4 of the connection terminal 2, retaining the connection terminal 2, and the flat portion 3 of the connection terminal 2 is supported on the flat seating 109 of the first movable part 102a, ensuring electrical contact between the connection plate 211 or 212 of the DC busbar 210 and the connection terminal 2. In this way, when the connection terminal 2 is inserted and the set screw 112 is in the final screwed-in position, the set screw 112 presses the connection terminal 2 against the first movable part 102a, overcoming the pressure of the spring 104 and establishing electrical contact between the connection terminal 2 and the connection plate 211 or 212 through the first movable part 102a.

Right before the projection 110 fits in the hole 4 of the connection terminal 2, the first movable part 102a moves up suddenly causing the flat seating 109 and the flat portion 3 of the connection terminal 2 to hit one another, generating the noise which is used as a mechanical feedback signal to identify the proper coupling of the connection terminal 2 with the connection plate.

Figure 7d again shows the set screw 112 in the initial screwed-in position, and the connection terminal 2 inserted in the upper portion 106 of the first movable part 102a but in a release position which allows the removal thereof from the housing 103 of the connector body 101. In this way, when the connection terminal 2 is inserted and the set screw 112 is in the initial screwed-in position, by applying force F on the second movable part 102b, the second movable part 102b and the first movable part 102a are moved, overcoming the pressure of the spring 104 and releasing the connection terminal 2. In other words, force F is applied on the set screw and the movable parts 102a and 102b are axially moved as a result of being driven, overcoming the pressure of the spring 104.

The AC connector 400 comprises a connector body 401 with a housing 403 which houses a movable part 402 that is axially movable in the housing 403 of the connector body 401, and a spring 404 having one end attached to the connector body 401 and another end attached to the movable part 402, the spring 404 being comprised inside the housing 403. For example, one of the ends of the spring 404 is fitted in the connector body 401 and the other end is directly supported on the movable part 402.

Preferably, as can be seen in detail in Figures 8 and 10, the connector body 401 of the AC connector 400 comprises, for each connection plate 311, 312 and 313, a movable part 402 that is axially movable in a respective housing 403 of the connector body 401, and a respective spring 404 having one end attached to the connector body 401 and another end attached to its respective movable part 402.

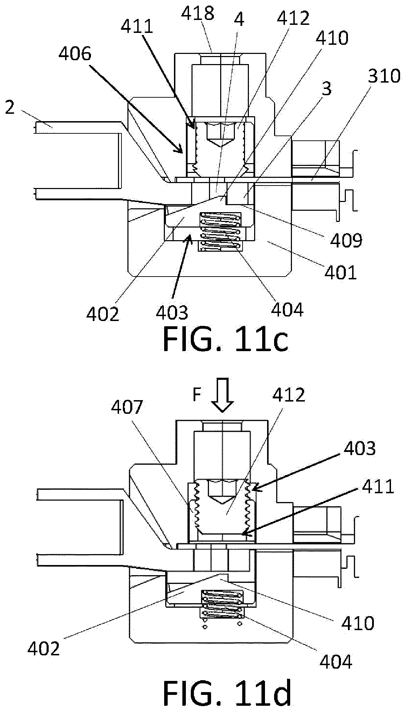

As can be seen in Figure 8a, each movable part 402 has a lower portion 405 which is pressed by the spring 404, a hollow central portion 406 in which one of the connection plates 311, 312, or 313 is arranged and in which the flat portion 3 of one of the connection terminals 2 can be inserted in order to contact the connection plate 311, 312, or 313, and an upper portion 407 which is configured to receive a force F and to axially move the movable part 402 overcoming the pressure of the spring 404, such that when the connection terminal 2 is inserted in the hollow central portion 406 of the movable part 402, the movable part 402 is pressed by the spring 404, forcing contact between the connection terminal 2 and the connection plate 311, 312, or 313 (see Figure 11c), and when force F is applied on the upper portion 407 of the movable part 402, the pressure of the spring 404 is overcome, releasing the connection terminal 2 (see Figure 11d).

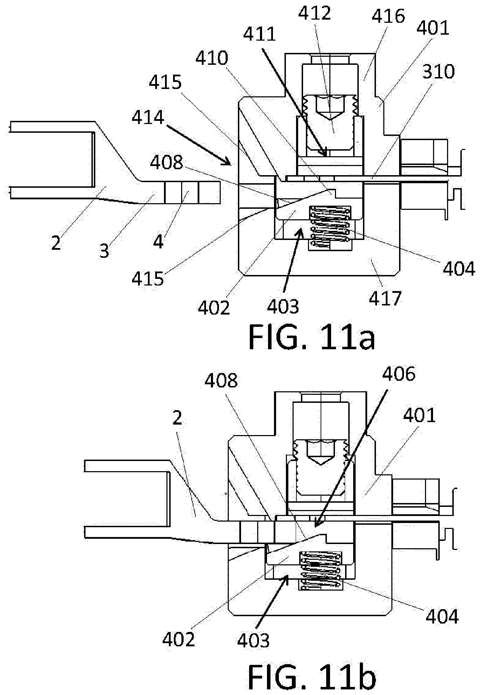

Preferably, the lower portion 405 of the movable part 402 has a lower face attached to the spring 404 and an upper face with a ramp 408 for contacting the connection terminal 2, such that when the connection terminal 2 is inserted in the hollow central portion 406 of the movable part 402, the connection terminal 2 contacts the ramp 408, overcoming the pressure of the spring 404 and axially moving the movable part 402. As can be seen in Figure 11b, the ramp 408 has an increasing slope in the direction of insertion of the connection terminal 2 which causes a gradual movement of the movable part 402.

Even more preferably, the lower portion 405 of the movable part 402 has on the upper face a flat seating 409 for supporting the flat portion 3 of the connection terminal 2 when the connection terminal 2 is inserted in the hollow central portion 406 of the movable part 402, it is thereby ensured that the flat portion 3 of the connection terminal 2 has a wide surface to contact the movable part 402 and that the risk of hot spots occurring due to a poor contact is minimized.

Even more preferably, the lower portion 405 of the movable part 402 has on the upper face a projection 410 projecting from the flat seating 409, the projection 410 being fitted in the hole 4 of the flat portion 3 of the connection terminal 2 when the connection terminal 2 is inserted in the hollow central portion 406 of the movable part 402. The projection 410 retains the connection terminal 2, preventing the accidental removal thereof. Furthermore, during the insertion of the connection terminal 2, when the projection 410 is to be fitted in the hole 4 of the connection terminal 2, the movable part 402 moves up suddenly until the flat seating 409 hits against the flat portion 3 of the connection terminal 2, generating a noise which can be used as a mechanical feedback signal to identify the proper coupling of the connection terminal 2 with the connection plate. This allows not having to have large windows in the casing 10 to enable viewing the connection terminal 2 from the outside and to enable viewing that the coupling between the terminal 2 and the plate is being properly performed, as occurs in known power converters.

Preferably, the upper portion 407 of the movable part 402 has a threaded hole 411 for screwing a set screw 412 therein and pressing the connection plate 311, 312, or 313 against the flat portion 3 of the connection terminal 2. The force F for moving the movable part 402 and overcoming the pressure of the spring 404 releasing the connection terminal 2 is applied by means of the set screw 412.

The set screw 412 can be partially screwed into the threaded hole 411 and is part of the movable part 402, such that the possibility of losing the set screw 412 or of it falling into the casing 10, as may occur in power converters using large windows, is prevented.

The set screw 412 has a diameter greater than the hole of the connection plates 311, 312, or 313 in order to prevent the passage of the screw 412 through said hole. Unlike known power converters, a nut and a screw which passes through the holes of the connection terminal 2 and the connection plate 311, 312, or 313 is not used, rather the connection terminal 2 and the connection plate are retained between the set screw 412 and the flat seating 409 of the movable part 402.

As can be seen in Figure 10, the connector body 401 has a non-threaded hole 413 for receiving the set screw 412 and directing it towards the threaded hole 411 of the upper portion 407 of the movable part 402.

The set screw 412 is partially screwed into the threaded hole 411 of the upper portion 407 of the movable part 402, and the non-threaded hole 413 of the connector body 401 has an inlet area 418 for a screwing tool having a diameter smaller than the diameter set screw 412 so as to allow screwing the set screw 412 therein and prevent it from coming out.

As can be seen in Figure 8, the connector body 401 has an inlet opening 414 with an inclined front portion 415 that inclines towards the inside of the housing 403 of the connector body 401 in order to direct the connection terminal 2 towards the hollow central portion 406 of the movable part 402. Preferably, the connector body 401 comprises an upper half-body 416 and a lower half-body 417, the upper half-body 416 has a first inclined front portion 415 and the lower half-body 417 has a second inclined front portion 415. The upper half-body 416 has a first inclined front portion 415 for each housing 403, and the lower half-body 417 has a second inclined front portion 415 for each housing 403.

Figures 11a to 11d show the steps for connecting a connection terminal 2 in the AC connector 400.

Figure 11a shows the connection terminal 2 facing the inlet opening 414 of the connector body 401, and the spring 404 is comprised inside the housing 403. In that standby position, the ramp 408 of the movable part 402 is facing the inlet opening 414 and the spring 404 is forcing the movable part 402 to move upwards, with the axial travel of the movable part 402 being limited because it abuts the upper half-body 416 of the connector body 401. In that standby position, the set screw 412 is partially screwed into the threaded hole 411 of the movable part 402. The two inclined front portions 415 of the half-bodies 416 and 417 direct the connection terminal towards the ramp 408 of the movable part 402.

Figure 11b shows the connection terminal 2 in an intermediate insertion position partially inserted in the hollow central portion 406 of the movable part 402 and contacting the ramp 408 so as to overcome the pressure of the spring 404 and to axially move the movable part 402 downwards.

Figure 11c shows the connection terminal 2 inserted in the hollow central portion 406 of the movable part 402 in an electrical contact position in which the flat portion 3 of the connection terminal 2 contacts the connection plate of the AC busbar 310. In the electrical contact position, the projection 410 of the movable part 402 is fitted in the hole 4 of the connection terminal 2, retaining the connection terminal 2, and the flat portion 3 of the connection terminal 2 is supported on the flat seating 409 of the movable part 402, ensuring electrical contact between the connection plate of the AC busbar 310 and the connection terminal 2. Furthermore, the set screw 412 is screwed into the hole 411 contacting the connection plate of the AC busbar 310, with the connection plate and the connection terminal 2 being retained between the set screw 412 and the flat seating 409 of the movable part 402.

Right before the projection 410 fits in the hole 4 of the connection terminal 2, the movable part 402 moves up suddenly causing the flat seating 409 to hit against the flat portion 3 of the connection terminal 2, generating the noise which is used as a mechanical feedback signal to identify the proper coupling of the connection terminal 2 with the connection plate.

Figure 11d shows the connection terminal 2 inserted in the hollow central portion 406 of the movable part 402 but in a release position which allows the removal thereof from the housing 403 of the connector body 401. When a force F is applied on the upper portion 407 of the movable part 402, the pressure of the spring 404 is overcome, releasing the connection terminal 2. To that end, first, the set screw 412 is partially unscrewed from the threaded hole 411, and second, force F is applied by means of the set screw 412, causing the movable part 402 to move downwards against the pressure of the spring 404, and the projection 410 to be released from the hole 4 of the connection terminal 2.

The inverter module 300 has a current sensor 320 arranged in each connection plate 311, 312, and 313 of the AC busbar 310 for measuring the current circulating through the connection plates 311, 312, and 313. See Figure 4.

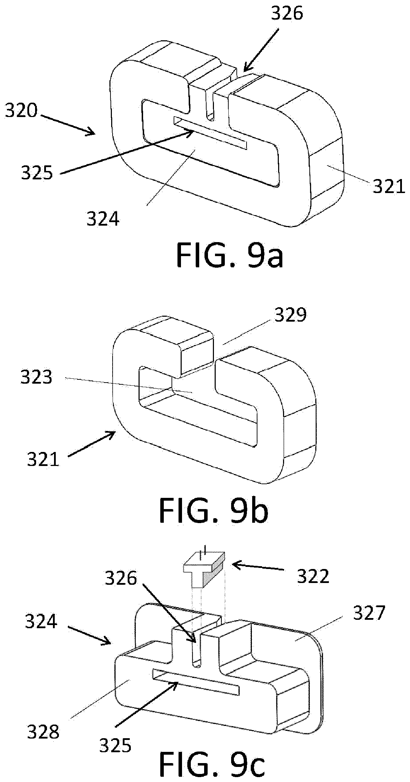

As shown in Figure 9a, each the current sensor 320 comprises a core 321 made of a ferromagnetic material and a Hall effect sensor 322. The core 321 made of a ferromagnetic material defines a cavity 323 in which the connection plate 311, 312, 313 of the AC busbar 310 is arranged, with the connection plate 311, 312, 313 of the AC busbar 310 passing through the center of the core 321 made of a ferromagnetic material.

The Hall effect sensor 322 measures the intensity of the magnetic field in the vicinity and the core 321 made of a ferromagnetic material is used to concentrate and confine the magnetic field lines generated by the current circulating through the connection plate 311, 312, 313 and also to provide a shielding effect which protects the Hall effect sensor 322 from other magnetic fields generated outside the core 321 made of a ferromagnetic material, such that the Hall effect sensor 322 can measure the current circulating through the connection plate 311, 312, 313 of the AC busbar 310.

Furthermore, the current sensor 320 comprises a central support 324 which is fitted in the cavity 323 of the core 321 made of a ferromagnetic material. The central support 324 has a first housing 325 in which the connection plate 311, 312, 313 of the AC busbar 310 is arranged and a second housing 326 in which the Hall effect sensor 322 is arranged.

Any change in the position or angle of the Hall effect sensor 322 with respect to the connection plate 311, 312, 313 would correspond to a change in the detected magnetic field that would prevent the attainment of an accurate measurement, so the central support 324 ensures the holding of the current sensor 320 by centering the core 321 made of a ferromagnetic material with respect to the Hall effect sensor 322 and to the connection plate 311, 312, 313, and limiting relative movements between the Hall effect sensor 322, the connection plate 311, 312, 313, and the core 321 made of a ferromagnetic material in a simple and compact manner. A power converter with current sensors arranged in a safe and compact manner is thus provided.

As can be seen in the example of Figure 3, the power converter comprises a printed circuit 500 with control electronics to control the power converter. The signal of the current sensor 320 is delivered to said printed circuit 500 electrically connecting the Hall effect sensor 322 with the printed circuit 500.

The Hall effect sensor 322 can be welded to said printed circuit 500 such that the Hall effect sensor 322 is housed in the first housing 325 of the central support 324 when the printed circuit 500 is arranged above the inverter module 300.

Preferably, as can be seen in Figure 9c, the central support 324 comprises a base 327 which contacts a rear face of the core 321 made of a ferromagnetic material and a projection 328 projecting from the base 327, the projection 328 comprising the first housing 325 and the second housing 326. This thereby facilitates and favors the repetitiveness of the assembly of the current sensor, ensuring that the Hall effect sensor is arranged at the same level as the core made of a ferromagnetic material.

Preferably, as can be seen in Figures 9a and 9b, the core 321 made of a ferromagnetic material has a separation opening 329, with the second housing 326 being positioned in said separation opening 329, such that the flux density in the separation opening is greater, increasing the sensitivity of the Hall effect sensor.

Preferably, the central support 324 is made of a plastic material such as, for example, low-density polypropylene or polyethylene. In addition to being a good electrical insulator, plastic has a relatively low permeability compared to the core made of a ferromagnetic material.

Even more preferably, the portion of the central support 324 in which the second housing 326 is arranged is flexible and the Hall effect sensor 323 fits in the second housing 326 by means of snap action, such that the sensor Hall 323 is held in a fixed position with respect to the connection plate 311, 312, 313 without being damaged. This configuration is particularly advantageous when the Hall effect sensor is welded to the printed circuit such as in the example of the embodiment shown in the figures as it allows correcting small positional deviations of the Hall effect sensor welded to the printed circuit.

Preferably, the central support 324 is integral with a body of an AC connector for connecting the connection terminals 2 of the second cables 5 with the connection plates 311, 312, 313 arranged in the AC connection portion 12, such that the current sensor is simplified and the actual body of AC connector perform the function of ensuring the holding of the current sensor indicated above.

## Claims

1. Power converter comprising a casing (10) with a first connection portion (11) for connecting first cables (1) having connection terminals (2) with a flat portion (3) with a hole (4) and a second connection portion (12) for connecting second cables (5) having connection terminals (2) with a flat portion (3) with a hole (4), a first busbar (210) having connection plates (211, 212) for establishing an electrical connection with the connection terminals (2) of the first cables (1), and a second busbar (310) having connection plates (311, 312, 313) for establishing an electrical connection with the connection terminals (2) of the second cables (5), **characterized in that** at least one of the connection portions (11) comprises a connector (100) for connecting the flat portion (3) of the connection terminals (2) with the connection plates (211, 212), the connector (100) comprises a connector body (101) with a housing (103) housing a first movable part (102a) and a second movable part (102b) which are axially movable in the housing (103) of the connector body (101), and a spring (104) having one end attached to the connector body (101) and another end attached to the first movable part (102a), with the spring (104) going through one of the connection plates (211, 212), the connection plate (211, 212) being arranged between the first movable part (102a) and the connector body (101);
the first movable part (102a) has a lower portion (105) which is pressed by the spring (104) and an upper portion (106) in which the flat portion (3) of one of the connection terminals (2) is insertable;
the second movable part (102b) is configured to receive a force (F) which axially moves the second movable part (102b) and the first movable part (102a), overcoming the pressure of the spring (104); and the second movable part (102b) has a threaded hole (111) for screwing a set screw (112) therein between an initial screwed-in position in which there is no electrical contact between the connection terminal (2) and the connection plate (211, 212) and a final screwed-in position in which there is electrical contact between the connection terminal (2) and the connection plate (211, 212);
such that when the connection terminal (2) is inserted and the set screw (112) is in the final screwed-in position, the set screw (112) presses the connection terminal (2) against the first movable part (102a), overcoming the pressure of the spring (104) and establishing electrical contact between the connection terminal (2) and the connection plate (211, 212) through the first movable part (102a); and
when the connection terminal (2) is inserted and the set screw (112) is in the initial screwed-in position, by applying force (F) on the second movable part (102b), the second movable part (102b) and the first movable part (102a) are moved, overcoming the pressure of the spring (104) and releasing the connection terminal (2).

2. Power converter according to claim 1, wherein the first movable part (102a) is made of an electrically conductive material.

3. Power converter according to the preceding claim, wherein the electrically conductive material comprises copper.

4. Power converter according to any of the preceding claims, wherein the lower portion (105) of the first movable part (102a) has a lower face attached to the spring (104) and an upper face with a ramp (108) for contacting the connection terminal (2), such that when the connection terminal (2) is inserted in the upper portion (106) of the first movable part (102a), the connection terminal (2) contacts the ramp (108), overcoming the pressure of the spring (104) and axially moving the first movable part (102a).

5. Power converter according to any of the preceding claims, wherein the lower portion (105) of the first movable part (102a) has on the upper face a flat seating (109) for supporting the flat portion (3) of the connection terminal (2) when the connection terminal (2) is inserted.

6. Power converter according to the preceding claim, wherein the lower portion (105) of the first movable part (102a) has on the upper face a projection (110) projecting from the flat seating (109), the projection (110) being fitted in the hole (4) of the flat portion (3) of the connection terminal (2) when the connection terminal (2) is inserted.

7. Power converter according to any of the preceding claims, wherein the connector body (101) comprises a cage (102c) which is arranged in the housing (103) of the connector body (101), and the first movable part (102a) and the second movable part (102b) are axially movable inside the cage (102c) of the connector body (101), with the spring (104) going through the connection plate (211, 212) and the lower portion (118) of the cage (102c), and the connection plate (211, 212) being arranged between the first movable part (102a) and the lower portion (118) of the cage (102c).

8. Power converter according to the preceding claim, wherein an inlet filter (220) of a capacitor module (200) is coupled to the upper portion (119) of the cage (102c), with the inlet filter (220) being arranged above the cage (102c).

9. Power converter according to any of the preceding claims, wherein the set screw (112) is partially screwed into the threaded hole (111) of the second movable part (102b), and the connector body (101) has a cap (120) with an inlet area (121) for a screwing tool having a diameter smaller than the diameter of the set screw (112) so as to allow screwing the set screw (112) therein and prevent it from coming out.

10. Power converter according to any of the preceding claims, wherein the casing (10) has threaded holes (15) for screwing therein cable glands (16) that fix the connection terminals (2) of the first cables (1) and the second cables (5) to the casing (10), with each connection terminal (2) being retained between a cable gland (16) and a threaded hole (15) of the casing (10).

11. Power converter according to any of the preceding claims, wherein the connector (100) is a DC connector (100) which is arranged in the first connection portion (11) for establishing an electrical connection between the connection terminals (2) of the first cables (1) and the connection plates (211, 212) of the first busbar (210).

12. Power converter according to the preceding claim, wherein the connector body (101) of the DC connector (100) comprises, for each connection plate (211, 212), a first movable part (102a) and a second movable part (102b) which are axially movable in a respective housing (103) of the connector body (401), and a respective spring (104) having one end attached to the connector body (101) and another end attached to its respective first movable part (102a).
